# EUROPÄISCHE PATENTSCHRIFT

(11) **EP 0 396 936 B1**
(45) Veröffentlichungstag und Bekanntmachung des Hinweises auf die Patenterteilung: **09.11.1994**
(21) Anmeldenummer: 90107194.4
(22) Anmeldetag: 14.04.1990
(51) Int. Cl.: H02G 3/04, H05K 9/00, H01B 11/10

(54) **Einrichtung zum Schutz elektrischer Anlagen**
Protection device for electrical installations
Dispositif pour la protection d'installations électriques

(30) Priorität: 06.05.1989 DE 3914929
(43) Veröffentlichungstag der Anmeldung: 14.11.1990
(73) Patentinhaber: Daimler-Benz Aerospace Airbus Gesellschaft mit beschränkter Haftung, 21129 Hamburg (DE)
(72) Erfinder: Kirma, Safa, D-2000 Wedel 7 Holstein (DE)
(74) Vertreter: Hansmann, Dierk, Dipl.-Ing.

(56) Entgegenhaltungen:
- DE-C- 534 339
- US-A- 3 351 699

## Beschreibung

Die Erfindung betrifft eine Einrichtung zum Schutz elektrischer Anlagen gegen elektromagnetische Störungen, insbesondere gegen Überspannungen und Blitzeinwirkungen, in Form metallischer Abschirmungen, die die zwischen den einzelnen elektrischen Geräten verlegten Leitungen umgeben und elektrisch mit Ableitpunkten verbunden sind.

Eine derartige Einrichtung ist aus der DE-C-534 339 bekannt.

Einrichtungen dieser Art werden insbesondere in Flugzeugen benötigt, in denen nicht nur auf relativ engem Raum eine große Anzahl elektrischer Geräte mit sehr unterschiedlichen Nutzsignalen und Störungsempfindlichkeiten angeordnet ist und bei denen die Möglichkeit gegenseitiger Beeinflussung zuverlässig ausgeschaltet sein muß, sondern die zugleich in ihrer Sicherheit durch die Auswirkungen eines Blitzeinschlages auf die elektronische Ausrüstung stark gefährdet sind.

Aus diesem Grunde stellt es eine bereits bekannte Maßnahme dar, elektrische Verbindungsleitungen in Flugzeugen, insbesondere auch ganze Kabelbäume, mit Abschirmungen aus metallisch leitendem Material zu versehen und diese Abschirmungen jeweils an den Enden mit den Gehäusen der elektrischen Geräten oder mit in diesen speziell vorgesehenen Masseleitungen zu verbinden.

Zu diesem Zweck wird im allgemeinen ein aus einzelnen Metallitzen bestehendes schlauchförmiges Geflecht verwendet, das, im Fall stromführender Steckerverbindungen, an den Kabelenden mit dem metallischen Stekkergehäuse verbunden ist. Häufig erfolgt die Verbindung dieses Geflechtes mit den vorgesehenen Ableitpunkten aber auch über separate Schellen, die an den Kabelenden das Geflecht umgeben und von denen aus eine separate Leitung, die auch als "pig tail" bezeichnet wird, zum Ableitpunkt geführt ist.

Ein Nachteil der bekannten Abschirmeinrichtungen liegt darin, daß infolge der im Geflecht verbleibenden freien Bereiche das Eindringen von Störfeldern, insbesondere bei den einem Blitzschlag auftretenden hohen Überspannungen, nicht zuverlässig ausgeschlossen werden kann. Ferner ist es bei diesen bekannten Einrichtungen ein häufig auftretendes Problem, daß die als Anschlußelemente für das Geflecht verwendeten Steckverbindungen aus Aluminium-Werkstoffen zur Korrosion neigen und daher störanfällig sind. Schließlich ist ein Nachteil dieser bekannten Anordnungen darin zu sehen, daß die innerhalb einer derartigen Abschirmung verlegten Leitungen im Fall eines Defektes von außen nur sehr schwer zugänglich sind, wodurch eine etwaig erforderlich werdende Reparatur oder ein Austausch einer defekten Leitung mit einem erheblichen Aufwand verbunden ist.

Aufgabe der Erfindung ist es daher, eine Einrichtung der eingangs genannten Art so auszubilden, daß sie eine zuverlässige Schutzwirkung gegen die Einwirkung sowohl von Störspannungen jeder Art als auch mechanischen Schutz gewährleistet und daß sie insbesondere einen leichten Zugang zu den innerhalb der Abschirmung liegenden elektrischen Leitungen ermöglicht.

Die Lösung dieser Aufgabe erfolgt erfindungsgemäß durch eine Einrichtung mit den kennzeichnenden Merkmalen des Anspruchs 1. Vorteilhafte Weiterbildungen dieser Einrichtung, die insbesondere der weiteren Optimierung der durch die erfindungsgemäße Einrichtung erzielbaren Schutzwirkung und einer weitgehenden Vereinfachung ihres Aufbaues und der Montage dienen, sind in den weiteren Ansprüchen angegeben.

Dadurch, daß bei der Einrichtung gemäß der Erfindung als Abschirmung flexible, ein wellenförmiges Profil aufweisende, in Längsrichtung geteilte bzw. geschlitzte Hohlstränge aus einem elektrisch leitenden Material, insbesondere aus einem Metall, verwendet werden, ergibt sich nicht nur die angestrebte vollständige Schutzwirkung sowie die erleichterte Zugänglichkeit im Störungsfall, sondern es ergibt sich zugleich auf einfache Weise die Möglichkeit, den Verlauf von zu verlegenden Einzelleitungen und Kabelbäumen durch die Schläuche an entsprechenden Punkten fixierende Formteile auf einfache Weise festzulegen. Weiterhin ermöglicht diese erfindungsgemäß vorgesehene Maßnahme einen besonders einfach zu realisierenden Übergang zwischen der Abschirmung und endseitig angeordneten Steckern sowie den einfachen Einbau von Verzweigungen in Kabelbäume. Außerdem weist die Abschirmung gemäß der Erfindung aufgrund der strukturierten Ausbildung der Hohlstränge eine hohe mechanische Stabilität auf, die zugleich ein erhebliche Gewichtsersparnis ermöglicht.

In folgenden soll die Erfindung, anhand von in der Zeichnung dargestellten Ausführungsbeispielen, näher erläutert werden. Es zeigen:
- Fig. 1: eine Prinzipdarstellung mit sich verzweigenden, Hohlsträngen in teilweise geschnittener Ansicht,
- Fig. 2 und 3: zwei Ausführungsformen einer Anordnung im Querschnitt,
- Fig. 4 bis 7: eine dritte Ausführungsform im Querschnitt, in Seitenansicht sowie zwei Draufsichten,
- Fig. 8 bis 12: eine vierte Ausführungsform im Querschnitt, in Seitenansicht sowie Bügelausbildungen zur Aufnahme von Kabelbündel,
- Fig.13 bis 19: eine fünfte Ausführungsform im Querschnitt in Seitenansicht sowie Bügelausbildungen zur Aufnahme von Kabelbündel.

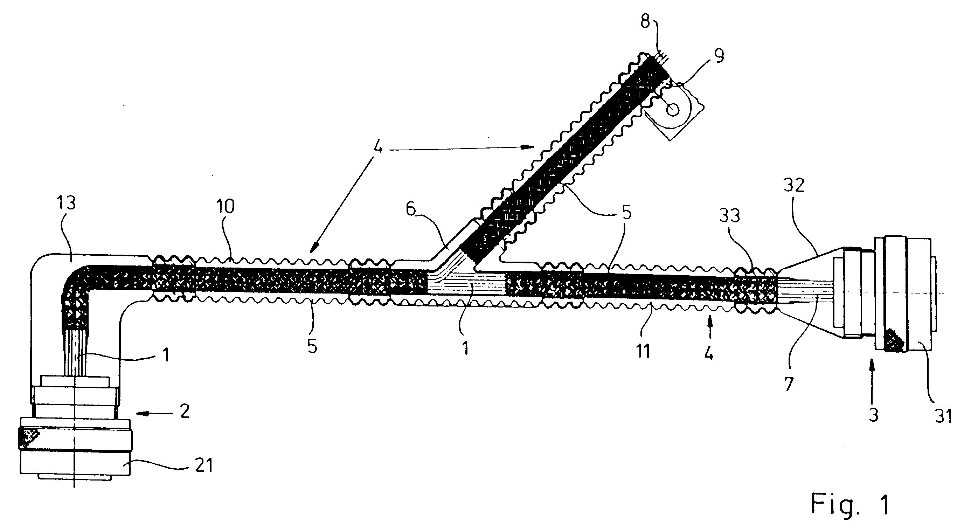

Bei der in Fig. 1 verkürzt dargestellten Anordnung handelt es sich um einen Kabelbaum 1, d.h. um eine zu einem Bündel zusammengefaßte Vielzahl elektrischer Verbindungsleitungen, die im Fall des hier beschriebenen Ausführungsbeispieles im Inneren eines Flugzeuges zwischen hier nicht dargestellten Komponenten der elektrischen Ausrüstung verlegt sind. Der Anschluß des Kabelbaumes 1 an diese Geräte erfolgt jeweils über vielpolige Steckverbindungen, wobei an den Enden der Anschlußelemente 2,3 angeordnet sind.

Zum Schutz gegen elektromagnetische Störungen, vor allem gegen Überspannungen, wie sie insbesondere als Folge von Blitzeinschlägen auftreten können, ist der Kabelbaum 1 von einer Abschirmung umgeben, die aus einem flexiblen, in Längsrichtung geteilten Metallstrang 4 besteht, der ein Wellprofil besitzt und von dem in der Zeichnung nur der untere Teil dargestellt ist, der zudem unterhalb der Verbindungsstelle zum oberen, als Abdeckung fungierenden Teil aufgeschnitten ist. Zusätzlich ist, als Schutz gegen etwaiges Scheuern bzw. andere mechanische Beanspruchungen, der Kabelbaum 1 mit einem Kunststoffgeflecht 5 überzogen, das im Inneren des Hohlstranges 4 liegt.

Wie aus der Darstellung gemäß Fig. 1 hervorgeht, ist der Kabelbaum 1 an einem Verzweigungselement 6 in zwei getrennt weiterlaufende Teilstränge 7,8 aufgeteilt, von denen der in der Zeichnung der Teilstrang 8 nur zum Teil dargestellt ist, da er an dieser Stelle durch eine in der Zeichnung nicht dargestellte Abtrennung verläuft. An dieser Stelle ist ein weiteres Anschlußelement 9 angeordnet, das sowohl der Herstellung einer Masseverbindung als auch der Fixierung des Teilstranges 8 dient.

Der Hohlstrang 4 ist in Längsrichtung aus mehreren Teilelementen 10 bis 12 zusammengesetzt. Schließlich ist an dem in der Zeichnung linken Ende des Teilelementes 10 der Abschirmung Formteil 13 vorgesehen, das in das Anschlußelement 2 übergeht und durch das der Kabelbaum 1 eine Umlenkung von 90 Grad erfährt. Bei den beiden Anschlußelementen 2 und 3 handelt es sich um vielpolige Rundsteckverbinder, die jeweils mittel einer Überwurfmutter 21 bzw. 31 in einer entsprechenden, hier nicht dargestellten Gerätedose verriegelbar sind. Der Anschlußelement 3 ist mit einem Gehäuse 32 versehen, das mit einer zweiteiligen Buchse 33 verbunden ist. Letztere weist auf ihrer Außenseite das gleiche wellenförmige Profil auf wie das Teilelement 11 des Hohlstranges 4 und ist formschlüssig mit diesem verbunden. Die gleiche formschlüssige Verbindung besteht auch zwischen dem Verzweigungselement 6 und den drei Teilelementen 10 bis 12 sowie zwischen dem Anschlußelement 9 und dem Teilelement 12 des Hohlstranges 4.

Auf den Aufbau des flexiblen Abschirmstranges 4, der in diesem Fall ebenfalls aus Metall, vorzugsweise Nickel besteht, der aber gleichfalls - zumindest zu Teil - aus Kunststoff bestehen kann, wird im folgenden im Detail eingegangen:

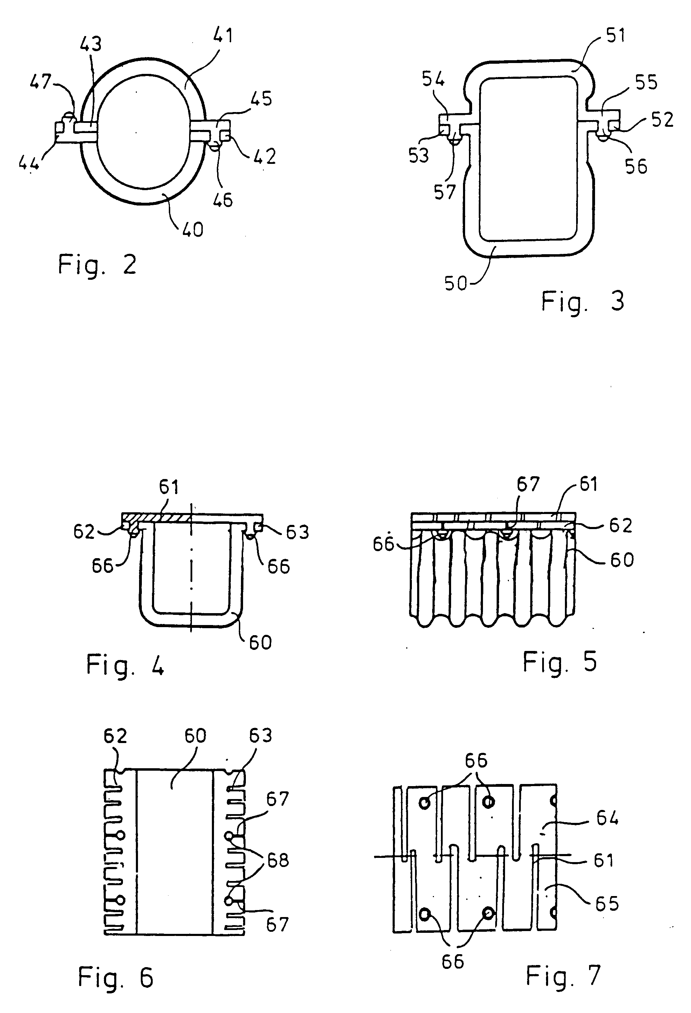

Gemäß den Figuren 2 und 3 Querschnitte durch als Abschirmstrang dienende Schläuche mit Wellenprofil dargestellt. Der Schlauch gemäß Fig.2 besteht aus zwei gleichartig geformten Hälften 40 und 41, die jeweils mit Stegen 42 bis 45 versehen sind. Die zur oberen Hälfte gehörenden Stege 44 und 45 sind dabei in regelmäßigen Abständen mit Noppen 46 und 47 versehen, die durch entsprechende Bohrungen greifen und die beiden Hälften 40 und 41 lösbar miteinander verbinden. Selbstverständlich kann der Schlauch auch einen Kreisquerschnitt haben.

In der Ausbildung gemäß in Fig. 3 besitzt der Schlauch einen angenähert rechteckigen Querschnitt. In diesem Fall sind ferner die beiden Hälften 50 und 51 unterschiedlich tief ausgebildet, wobei die untere Hälfte 50 quasi als Kabelkanal zur Aufnahme eines hier nicht dargestellten Kabelbaumes dient, während die obere Hälfte 51 die Abdeckung bildet. Auch in diesem Fall wird durch auf Stegen 52 bis 55 angeordnete Noppen 56 und 57 eine lösbare Verbindung zwischen den beiden Hälften 50 und 51 hergestellt. Die in den Figuren 2 und 3 dargestellten, jeweils mit einem wellenförmigen Profil versehenden Schläuche oder Stränge bestehen in diesem Fall aus einem metallisierten, wie einen vernickelten, Kunststoff.

Bei der in den Figuren 4 bis 7 dargestellten Anordnung ist der als Abschirmung dienende Hohlstrang nach Art eines Kabelkanals ausgebildet, d.h. er besteht aus einem U-förmigen unteren Teilelement 60 und einer flachen Abdeckung 61, die so breit ausgebildet ist, daß sie auf seitlich am Teilelement 60 angesetzten Stegen 62 und 63 aufliegt. Die Abdeckung 61 greift mit zwei in Längsrichtung verlaufenden Ansätzen 64 und 65 in die Öffnung des Teilelementes 60 und zugleich mit Noppen 66 in mit einem seitlichen Schlitz 67 versehende Bohrungen 68 in den Stegen 62 und 63. Auch in diesem Fall können die beiden den Hohlstrang bildenden Teilelemente 60 und 61 entweder aus Metall oder aber aus metallisierten Kunststoff bestehen. Wie insbesondere die seitliche Ansicht in Fig. 5 zeigt, erstreckt sich das Wellprofil in diesem Fall nur auf das untere Teilelement 60.

In den vorgenannten Figuren sind jeweils Abschirmeinrichtungen dargestellt, bei denen der innenliegende Kabelbaum vorzugsweise durch ein diesen umgebendes Kunststoffgeflecht gegen mechanische Beanspruchen, insbesondere gegen das Scheuern an den Innenwänden der profilierten Hohlstränge, geschützt wurde. Hieraus resultiert im Reparaturfall der zusätzliche Arbeitsgang, daß das Kunststoffgeflecht zunächst aufgeschnitten und nach erfolgter Reparatur durch eine geeignete Bandage wieder verschlossen werden muß. Die nachfolgend dargestellten Ausführungsbeispiele vermeiden diesen zusätzlichen Arbeitsgang durch eine in periodischen Abständen erfolgende Fixierung des Kabelbaumes im Inneren des Hohlstranges.

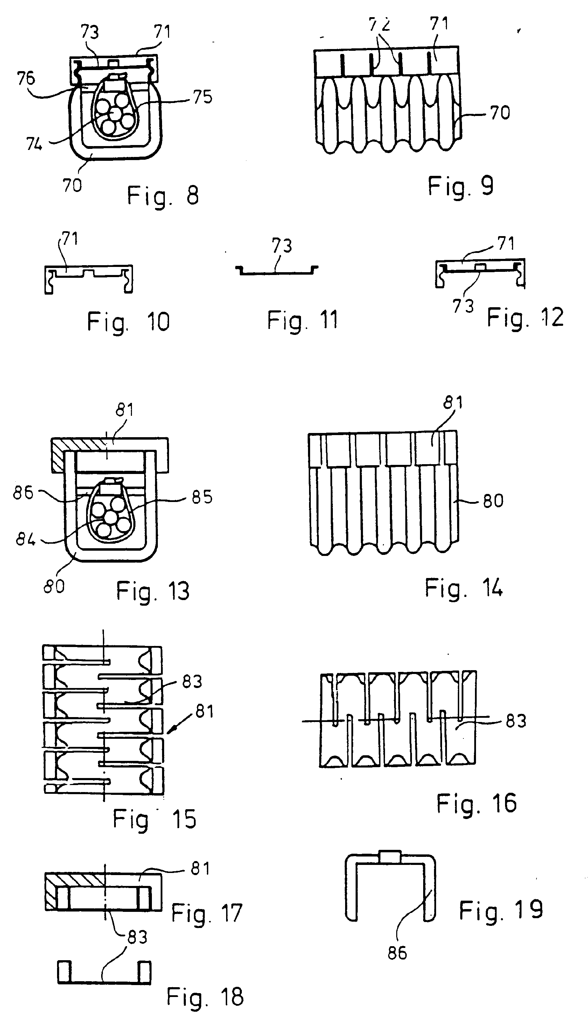

Die in den Figuren 8 bis 12 abgebildete Anordnung stellt wieder einen Kabelkanal dar, der von einem mit Wellenprofil versehenden, U-förmigen unteren Teilelement 70 sowie einer Abdeckung 71 besteht, die über entsprechend geformte Ansätze des unteren Teilelementes 70 greift und die diesen abschließt. Während das untere Teilelement 70 in diesem Fall wieder aus Metall bzw. metallisiertem Kunststoff besteht, ist die Abdeckung 71 aus einem einfachen Kunststoff hergestellt und mit seitlichen Schlitzen 72 versehen. Zur Erzielung einer vollständig geschlossenen Abschirmwirkung gegen elektromagnetische Störungen bzw. Überspannungen ist in die Abdeckung 71 eine durchgehende Metallschiene 73 eingesetzt, die bei geschlossenem Kabelkanal in elektrischem Kontakt mit dem untern Teilelement steht. Wie aus der Querschnittsdarstellung in Fig. 8 weiter hervorgeht, ist ein im Inneren des Kabelkanals verlegtes Kabelbündel 74 mittels Kabelbindern 75 an einem in periodischen Abständen in das untere Teilelement 70 eingesetzten Bügel 76 fixiert. Dieser Bügel 76 hat die gleiche Gestalt wie der in Fig. 19 dargestellte Bügel 86 und wird von oben in eine der wellenförmigen Ausbuchtungen des Teilelementes 70 eingesteckt, deren äußerer Form er angepaßt ist.

Die in den Figuren 13 bis 19 dargestellte Anordnung stellt eine Variation des vorstehend beschriebenen Ausführungsbeispieles dar. Auch hier bilden ein unteres Teilelement 80 aus Metall bzw. metallisiertem Kunststoff sowie eine Kunststoffabdeckung 81 zusammen einen Kabelkanal, in den an Bügeln 86 mittels Kabelbindern 85 eine Kabelbündel 84 eingehängt ist. Ein Fall dieses Ausführungsbeispieles ist das wellenförmige Profil des untern Teilelementes 80 bis zu dessen oberer Kante hochgezogen.

Die auch bei diesem Ausführungsbeispiel vorgesehene Metallschiene 83, die in die Abdeckung 81 eingesetzt wird und die zusammen mit dem untern Teilelement 80 eine geschlossene Abschirmung bildet, ist in diesem Fall U-förmig ausgebildet ist, wobei die Schenkel ebenfalls ein wellenförmiges Profil aufweisen. Dies geht aus den Detaildarstellungen der Figuren 17 und 19 hervor. Die Figuren 15 und 17 zeigen schließlich, daß die Breite der Schiene 83 so gewählt ist, daß sie exakt in die gleichfalls U-förmig ausgebildete Abdeckung 81 paßt.

Der in Fig. 19 dargestellte Kunststoffbügel 86 weist abgerundete Schenkel auf, mit denen er sich ebenfalls exakt in das Innere des Wellenprofils des unteren Teilelementes 80 einsetzen läßt. Das an diesem Bügel 86 aufgehängte Kabelbündel 84 ist dadurch gegen jeden Kontakt und damit Abrieb an den Wänden des Kabelkanals geschützt.

## Patentansprüche

1. Einrichtung zum Schutz elektrischer Anlagen gegen elektromagnetische Störungen, insbesondere Überspannungen und Blitzeinwirkungen, in Form metallischer Abschirmungen, die die zwischen den einzelnen elektrischen Geräten verlegten Leitungen umgeben und elektrisch leitend mit Ableitpunkten verbunden sind, dadurch gekennzeichnet, daß die Abschirmungen als in Längsrichtung geteilte,ein wellenförmiges Profil aufweisende flexible Hohlstränge (4,10-12) aus elektrisch leitenden Material in der Art von verschließbaren Aufnahmen ausbildbar sind.

2. Einrichtung nach Anspruch 1, dadurch gekennzeichnet, daß die Hohlstränge (4,10-12) als geteilte Profilschläuche (40,41,50,51) ausgebildet sind.

3. Einrichtung nach Anspruch 1, dadurch gekennzeichnet, daß die Hohlstränge (4,10-12) in der Art eines Schlauches mit einer in Längsrichtung verlaufende und verschließbaren Trennfuge ausgebildet sind.

4. Einrichtung nach einem der Anspruch 1 bis 3, dadurch gekennzeichnet, daß die Hohlstränge (4,10-12) aus metallisiertem Kunststoff bestehen.

5. Einrichtung nach Anspruch 1, dadurch gekennzeichnet, daß die Hohlstränge (4,10-12) als u-förmige Kabelkanäle ausgebildet sind.

6. Einrichtung nach Anspruch 5, dadurch gekennzeichnet, daß die unteren Grundelemente (70,80) der Kabelkanäle aus einem Metall oder metallisiertem Kunststoff bestehen, während die Abdeckungen (71,81) aus einem elektrisch nichtleitenden Kunststoff bestehen und mit einer innenliegenden metallischen Schiene (73,83) versehen sind.

7. Einrichtung nach einem der Ansprüche 1 bis 6, dadurch gekennzeichnet, daß ein in den Hohlsträngen (4,10-12) verlegtes Kabelbündel (74,84) an in regelmäßigen Abständen angeordneten, in das Wellenprofil eingesetzten Bügeln (76,86) gehaltert ist.

8. Einrichtung nach einem der Ansprüche 1 bis 7, dadurch gekennzeichnet, daß ein in den Hohlsträngen (4,10-12) verlegtes Kabelbündel (1,7,8) mit einem Kunststoffgeflecht (5) überzogen ist.

9. Einrichtung (70,81,80,81) nach einem der Ansprüche 1 bis 8, dadurch gekennzeichnet, daß die Elemente der Kabelkanäle durch Noppen (46,47,56,57) und zugeordneter Aufnahmen (68) druckknopfartig verbindbar sind.

## Claims

1. Device for protecting electrical installations against electromagnetic interference, in particular overvoltages and the effects of lightning, in the form of metal screens which surround the cables laid between the individual electrical appliances and are connected in an electrically conductive manner to arrester points, characterized in that the screens take the form of longitudinally split, flexible hollow tracks (4, 10-12) having an undulating profile and made from electrically conductive material in the manner of closable receivers.

2. Device according to claim 1, characterized in that the hollow tracks (4, 10-12) take the form of split shaped tubes (40, 41, 50, 51).

3. Device according to claim 1, characterized in that the hollow tracks (4, 10-12) are constructed in the manner of a tube having a parting line which is closable and extends in a longitudinal direction.

4. Device according to one of claims 1 to 3, characterized in that the hollow tracks (4, 10-12) are made of metallized plastic.

5. Device according to claim 1, characterized in that the hollow tracks (4, 10-12) take the form of U-shaped cable channels.

6. Device according to claim 5, characterized in that the bottom basic elements (70, 80) of the cable channels are made of a metal or metallized plastic, while the covers (71, 81) are made of an electrically non-conductive plastic and are provided with a inner-lying metal rail (73, 83).

7. Device according to one of claims 1 to 6, characterized in that a cable bundle (74, 84) laid in the hollow tracks (4, 10-12) is supported on clips (76, 86) arranged at regular intervals and inserted into the undulating profile.

8. Device according to one of claims 1 to 7, characterized in that a cable bundle (1, 7, 8) laid in the hollow tracks (4, 10-12) is provided with a braided plastic coating (5).

9. Device (70, 81, 80, 81) according to one of claims 1 to 8, characterized in that the elements of the cable channels are connectable in a press-stud-like manner by means of studs (46, 47, 56, 57) and associated location holes (68).

## Revendications

1. Installation pour protéger des ensembles électriques contre les parasites électromagnétiques, notamment les surtensions et l'action des éclairs, sous la forme d'écrans métalliques qui entourent les conducteurs reliant les différents appareils électriques, ces écrans étant reliés électriquement à des points de sortie, installation caractérisée en ce que les écrans sont réalisés sous la forme de cordons creux (4, 10-12), souples, ayant un profil ondulé, ces cordons, en un matériau conducteur d'électricité, étant coupés longitudinalement et réalisés sous la forme de moyens de réception susceptibles d'être fermés.

2. Installation selon la revendication 1, caractérisée en ce que les cordons creux (4, 10-12) sont des tubes profilés divisés (40, 41, 50, 51).

3. Installation selon la revendication 1, caractérisée en ce que les cordons creux (4, 10-12) sont réalisés à la manière d'un tuyau avec un joint longitudinal de séparation susceptible d'être fermé.

4. Installation selon l'une des revendications 1-3, caractérisée en ce que les cordons creux (4, 10-12) sont en matière plastique métallisée.

5. Installation selon la revendication 1, caractérisée en ce que les cordons creux (4, 10-12) sont constitués par des canaux de câbles à section en U.

6. Installation selon la revendication 5, caractérisée en ce que les éléments de base, inférieurs (70, 80) des canaux de câbles sont en métal ou en matière plastique métallisée et les moyens de couverture (71, 81) sont en matière plastique non conducteur d'électricité avec un rail métallique intérieur (73, 83).

7. Installation selon l'une des revendications 1-6, caractérisée par un faisceau de câbles (74, 84) placé dans les cordons creux (4, 10-12) en étant maintenu à intervalle régulier par des étriers (76, 86) placés dans le profil ondulé.

8. Installation selon l'une des revendications 1-7, caractérisée par un faisceau de câbles (1, 7, 8) placé dans les cordons creux (4, 10-12) en étant revêtu d'un tissu de matière plastique (5).

9. Installation (70, 71, 80, 81) selon l'une des revendications 1-8, caractérisée en ce que les éléments des canaux de câbles sont reliés par des boutons (46, 47, 56, 57) coopérant avec des logements (68) à la manière de boutons-pressions.
